# EUROPEAN PATENT APPLICATION

(11) **EP 2 230 720 A1**
(43) Date of publication of application: **22.09.2010**
(21) Application number: 09155787.6
(22) Date of filing: 20.03.2009
(51) Int. Cl.: H01Q 1/38, H01Q 1/40, H01Q 9/06, H01Q 9/28, A61B 5/055, G01R 33/20

(54) **An antenna array comprising at least one dipole antenna for magnetic resonance imaging**

(71) Applicant: Koninklijke Philips Electronics N.V., 5621 BA Eindhoven (NL)
(72) Inventor: The designation of the inventor has not yet been filed
(74) Representative: Damen, Daniel Martijn

(57) **Abstract**

An antenna array adapted for magnetic resonance imaging, wherein the antenna array comprises at least one antenna element, wherein each antenna element comprises:
- a substrate with a first side and a second side, wherein the substrate comprises a dielectric material,
- at least one dipole antenna, wherein the dipole antenna is attached to the second side of the substrate, wherein the dipole antenna comprises a first connection adapted for connecting the dipole antenna to a transmission line.

## Description

### FIELD OF THE INVENTION

The invention related to the design of dipole antennas for magnetic resonance imaging.

### BACKGROUND OF THE INVENTION

A static magnetic field is used by Magnetic Resonance Imaging (MRI) scanners to align the nuclear spins of atoms as part of the procedure for producing images within the body of a patient. This static magnetic field is referred to as the B₀ field. It is commonly known that increasing the strength of the B₀ field used for performing an MRI scan offers the opportunity of increasing the spatial resolution and contrast resolution of the diagnostics images. This increase in resolution and contrast benefits physicians using an MRI image to diagnose a patient.

During an MRI scan, Radio Frequency (RF) pulses generated by a transmitter coil cause perturbations to the local magnetic field. These perturbations are known as the B₁ field. The B₁ field is used to manipulate the orientation of the nuclear spins. The portion of the B₁ field that is effectively used to manipulate the orientation of the nuclear spins is the B₁⁺ field. RF signals that are emitted by the nuclear spins are detected by a receiver coil. These RF signals are used to construct the MRI images. These coils can also be referred to as antennas. Further, the transmitter and receiver coils can also be integrated into a single transceiver coil that performs both functions. It is understood that the use of the term transceiver coil also refers to systems where separate transmitter and receiver coils are used.

However, a technical challenge in increasing the B₀ field strength used is that as the B₀ field is increased, the frequency of the electromagnetic waves necessary to generate the B₁⁺ field also increases. Conventional MRI transceiver coils, are resonant and rely on near field radiation to generate the B₁⁺ field. As the frequency increases, the near field becomes confined to a smaller and smaller region. To image regions deep within the body of a subject, the surface regions of the subject can be exposed to levels of radiation which can overheat tissue. The term Specific Absorption Ratio (SAR) is the radio frequency power absorbed per unit mass in tissue and is a measure of this overheating. MRI transceiver coils which limit the SAR in a subject as the B₀ field increases are needed.

United States patent application publication US2009/0015256A1 discloses the use of stripline conductors in combination with loop coils to form quadrature detectors.

### SUMMARY OF THE INVENTION

The invention provides for an antenna array, a radio frequency system, a computer program product, and a magnetic resonance imaging system in the independent claims. Embodiments of the invention are given in the dependent claims.

Conventional Radio Frequency (RF) transmit coils in Magnetic Resonance (MR) imaging are 'near-field' antennas. These antennas store magnetic (and electric) energy in the near-field region around the antenna, causing high levels of B₁⁺. This region extends around the antenna for approximately a quarter of a wavelength (λ/4), which corresponds to ca. 20 cm for 1.5 T and 10 cm for 3 T imaging. However, at 7 Tesla, the near-field is extending only 4 cm into the subject. Many regions of interest for MR imaging are likely to be located outside the 'near-field' region. Resonant antennas are extremely inefficient in generating B₁⁺ in the 'far-field' region. To solve this problem, embodiments of the invention provide for a different kind of antenna, which is known as a 'radiative antenna'. This antenna is used in the field of RF hyperthermia. Instead of focusing the energy in the near-field region, the antenna is designed such that the energy will be radiated away from its source, resulting in more efficient B₁⁺ generation at depths beyond a quarter of a wavelength. With a number of these elements in a belt-like array around the body, combined with phase-amplitude steering of the individual elements, both the B₁⁺ level and B₁⁺ homogeneity can be increased.

Radiative antennas are able to transmit higher levels of B₁⁺ to regions inside the human body. Therefore, they will also be more sensitive to pick up signals from the body. This makes them suitable elements of RF coil arrays for both transmitting and receiving. For both applications, a belt-like coil array around the body with a number of these elements is used in combination with phase-amplitude steering of the elements. In this way, the RF interference patterns inside the body can be manipulated to avoid the appearance of signal voids in regions of interest, which would diminish the gain that the radiative elements inherently offer. The radiative antenna design that is presented here can operate over a wide range of frequencies, offering promising functionality for multi-nuclei MRI.

### Embodiments of the invention may have the following advantages:

For MR imaging at ultra high field strengths, the radiative antenna is able to transmit higher (with respect to dipole) signal levels into the deeper parts of the body.

The Specific Absorption Ratio (SAR) levels at the surface of the subject are reduced because the ratio of the B₁⁺ level at the point of interest versus the SAR level at the surface, is more favorable for a radiative antenna compared to traditional designs.

Due to the reduced surface SAR, the radiative antenna is also more suitable to deliver therapeutic levels of RF inside the subject e.g. for thermally activated drug delivery.

An array of radiative antenna elements allows for a multi-transmit approach, where the RF interference patterns can be controlled by varying phase and amplitude of the elements. In this way, signal voids can be removed from the target region.

This invention facilitates more effective MR spectroscopy for the prostate at 7 Tesla. This promises to become a valuable tool to characterize and/or distinguish tumor tissue, once the RF challenges of getting signal from deeper/more deeply located regions have been solved.

Although prostate cancer is given here as an example, many more tumor sites are eligible for investigation with MR spectroscopy once the RF challenges have been solved. Due to the increasing incidence of cancer all over the world, the characterization of tumor tissue by MR spectroscopy could in potential prove to be the first example where the 7 Tesla modality demonstrates clinical value for subjects. The application of the 7 Tesla for oncology is now hampered by the RF problems in the body. Any technique that can cope with these problems may in future become a valuable asset in MR imaging.

The broadband properties of this invention provide opportunities for multi-nuclei MRI.

Embodiments of the invention provide for an antenna array adapted for magnetic resonance imaging, where the antenna array comprises at least one element. Each element comprises a substrate with a first side and a second side. Each element further comprises at least one dipole antenna. The substrate comprises a dielectric material. The dipole antenna is attached to the second side of the substrate, and the dipole antenna comprises a first connection adapted for connecting the dipole antenna to a transmission line. This embodiment is advantageous, because this antenna can be used for launching or receiving radio frequency waves for performing magnetic resonance imaging. In another embodiment the antenna array has a substrate comprising dielectric material which has a dielectric constant between 20 and 110. This embodiment is advantageous, because the antenna can be placed in the vicinity of a subject and the dielectric material reduces the fraction of the electromagnetic wave that will be reflected. The first connection can be a connection adapted for transmitting radio frequency power such as an "SMA" or "N" type connector. The first connection can also be a hardwired connection between the dipole antenna and a transmission line.

In another embodiment, the dielectric material has an electrical conductivity that is lower than 0.1 S/m at the operating frequency of the longest wavelength that the dipole antenna is adapted for launching. This embodiment is advantageous, because this conductivity allows magnetic resonance imaging to function without large losses in the dielectric.

In another embodiment, the substrate is ceramic. This embodiment is advantageous, if the ceramic has a conductivity and also dielectric constant which is similar to that of human tissue. This means that the dielectric material matches the electrical properties of the human body and reduces reflections from the interface between the substrate and the subj ect.

In another embodiment, the dielectric constant of the dielectric material is equal to the average dielectric constant of the human body. The average dielectric constant of the human body can be calculated in several ways. The average of the entire body for a group of subjects can be calculated or the average for a certain region of a body can be calculated. For instance the average dielectric constant of a hand for a group of subjects can be calculated and this can be used. The advantage of matching the dielectric constant of the substrate to that of the human body has already been discussed.

In another embodiment, the antenna array is adapted for receiving radio frequency signals from nuclei inside a subject excited during the acquisition of magnetic resonance imaging data. Magnetic resonance imaging data is defined herein as a measurement of the radio frequency signals emitted by atomic nuclei during magnetic resonance imaging.

In another embodiment, the antenna array is adapted for launching an electromagnetic wave from the dipole antenna through the substrate in the direction of the first side for manipulating the orientation of the nuclear spins inside a subject during the acquisition of magnetic resonance imaging data. This embodiment is advantageous, because the dielectric can be used to direct the launching of an electromagnetic wave, and also the dielectric can be constructed such that the specific absorption ratio on the surface of a subject or also within a subject is reduced.

In another embodiment, the thickness of the substrate is chosen for reducing the specific absorption ratio in a subject. The radiation pattern of a dipole antenna can be described using the near field and the far field approximation. The terms near field and far field radiation patterns are understood to reference these approximations. The substrate thickness can be chosen large enough such that the near field is located solely inside the substrate and therefore outside of a subject. This reduces the specific absorption ratio that a subject is exposed to.

In another embodiment, the thickness of a substrate is greater than one eighth of the wavelength in the dielectric at the frequency of the longest wavelength that the dipole antenna is adapted for launching, preferably the thickness of a substrate is greater than one quarter of the wavelength in the dielectric at the frequency of the longest wavelength that the dipole antenna is adapted for launching. This embodiment is advantageous, because of reasons that have already been discussed.

In another embodiment, the dipole antenna comprises two conductive strips. The conductive strips are aligned along an axis, and the substrate extends along the axis beyond the end of each of the conductive strips at least one eighth of a wavelength of the longest wavelength that the dipole antenna is adapted for launching. Preferably the substrate extends along the axis and beyond the end of each of the conductive strips at least one quarter of a wavelength of the longest wavelength the dipole antenna is adapted for launching. This embodiment is advantageous, because the field of the dipole antenna is better contained by the dielectric material. That is the near field of the dipole antenna is contained within the dielectric. If the dielectric is too short then the near field radiation field is not contained within the dielectric and it can cause a high specific absorption ratio when the antenna is in the vicinity of a subject.

In another embodiment, the dipole antenna comprises two conductive strips. The conductive strips are aligned along an axis. The length each conductive strip are equal one quarter of the wavelength inside the dielectric material. In this way, the antenna is far more efficient in transmitting a wave in the direction of the first side than in the direction of the second side, because the total length of the dipole antenna is now half a wavelength in the dielectric but not in air.

In another embodiment, the antenna is adapted for launching at least two different frequencies of electromagnetic waves. This is advantageous, because the antenna array can then be used for multi-nuclei nuclear magnetic resonance imaging. Nuclei of several different types can be manipulated with the antenna or their signals can be detected with the antenna.

In another embodiment, the antenna is further adapted for launching electromagnetic waves for performing radio frequency hyperthermia treatment of the subject. This embodiment is advantageous, because the antenna can be used for magnetic resonance imaging and also the same antenna could then be used for heating tissue for hyperthermia treatment. The combination of these two is advantageous, because the temperature of tissue can be measured directly using magnetic resonance imaging. In this way the hyperthermia could be precisely guided and controlled using magnetic resonance imaging.

In another embodiment, the dipole antenna comprises two conductive strips. Each conductive strip is V-shaped and the two conductive strips are attached to the substrate such that the points of the V for both conductive strips are adjacent to each other. This embodiment is advantageous, because the V-shape increases the size of the antenna and therefore increases the size of the radiation field of the antenna. The antenna array can then be used for imaging a larger portion of a subject.

In another embodiment, the first side is adapted for receiving a subject. This embodiment is advantageous, because the antenna can be placed directly against the subject and this reduces the amount of reflection of electromagnetic radiation at the border of the subject and at the first side.

In another embodiment, the dielectric substrate comprises a fluid.

In another embodiment, the second side is adapted for receiving a gel that facilitates the transmission of electromagnetic waves from the first side to the subject. Both of these embodiments are advantageous, because this reduces the amount of reflection at the boundary between the subject and the second side. This improves the quality of the magnetic resonance imaging images.

In another embodiment, a portion of the substrate is powdered ceramic. The ceramic is then placed into a cushion and the cushion is then able to be adapted to the surface of the subject.

In another aspect, the invention provides for a radio frequency system for a magnetic resonance imaging system. The radio frequency system comprises an antenna according to any one of the preceding claims. The radio frequency system further comprises a radio frequency generator adapted for supplying each dipole antenna of the antenna array with radio frequency power with at least a first frequency. The radio frequency generator is adapted for controlling the amplitude and phase of the radio frequency power supplied to each dipole antenna. This is advantageous, because the phase and amplitude of each array can be controlled and adjusted as well as the phase. This allows the B₁⁺ field within the subject to be made more uniform and to improve the homogeneity of the B₁⁺ field and the level. The radio frequency system further comprises a set of transmission lines adapted for connecting the first connection and the second connection. The radio frequency system further comprises a set of transmission lines adapted for connecting the first connection and the second connection. The radio frequency system further comprises a control system adapted for controlling the radio frequency generator. This control system can be a dedicated computer, microcontroller or control system. The control system can also be integrated as part of a computer system for controlling the magnetic resonance imaging system. The control system can therefore also comprise a software component.

In another embodiment, the radio frequency generator is further adapted for receiving radio frequency signals from excited nuclei by the antenna array, and wherein the radio frequency generator is a transceiver adapted for receiving the radio frequency signals from the antenna array.

In another aspect, embodiments of the invention provide for a computer program product comprising machine executable instructions for execution on the control system of the radio frequency system. The machine executable instructions comprise the steps of adjusting the amplitude of the radio frequency energy received by each dipole antenna from the radio frequency generator in order to increase the level of homogeneity of the B₁⁺ field within the subject, and adjusting the phase of the radio frequency energy received by each dipole antenna from the radio frequency generator in order to increase the level of homogeneity of the B₁⁺ field within the subject. This embodiment is advantageous, because increasing the level and/or homogeneity of the B₁⁺ field within the subject improves the quality of the images acquired using magnetic resonance imaging.

In another aspect, embodiments of the invention provide for a magnetic resonance imaging system adapted for acquiring magnetic resonance imaging data. The magnetic resonance imaging system comprises a magnetic field generation means for generating a magnetic field for orientating the magnetic spins of nuclei, a radio frequency system according to an embodiment of the invention, a magnetic field gradient coil for spatial encoding and manipulating the orientation of the magnetic spins in the nuclei, and a magnetic field generation coil power supply for supplying current to the magnetic field of the gradient coil, and a second control system for reconstructing images from the magnetic resonance imaging data. The full system of the radio frequency system and the second control system of the magnetic resonance imaging system can be identical. They can also be separate control systems but can share software components on a shared computer.

### BRIEF DISCRIPTION OF THE DRAWINGS

In the following preferred embodiments of the invention will be described, by way of example only, and with reference to the drawings in which:
Figure 1 shows a drawing of an antenna element according to an embodiment of the invention,
Figure 2 shows a functional diagram of a radio frequency system according to an embodiment of the invention,
Figure 3 shows a functional diagram of a radio frequency system according to a further embodiment of the invention,
Figure 4 shows a drawing of an embodiment of an antenna array according to an embodiment of the invention,
Figure 5 shows a function diagram of a magnetic resonance imaging system according to an embodiment of the invention,
Figure 6 shows a functional diagram of a radio frequency system according to a further embodiment of the invention,
Figure 7 shows machine executable steps for an embodiment of a computer program product according to the invention,
Figure 8 shows a drawing of an antenna element according to a further embodiment of the invention,
Figure 9 shows a drawing of an antenna element according to a further embodiment of the invention,
Figure 10 shows a plot of simulated specific absorption ratio levels in a phantom,
Figure 11 shows a plot of the maximum specific absorption ratio and the value of B₁⁺ as a function of the substrate thickness,
Figure 12 shows an embodiment of a dipole antenna according to the invention,
Figure 13 shows a series of plots showing simulation results comparing a dipole antenna according to the embodiment of the invention with a conventional radiative antenna,
Figure 14 shows plots of the real and imaginary impedance values for a dipole antenna according to an embodiment of the invention and a conventional radiative antenna,
Figure 15 shows an example of a magnetic resonance imaging image acquired using a dipole antenna according to an embodiment of the invention.

### DETAILED DESCRIPTION

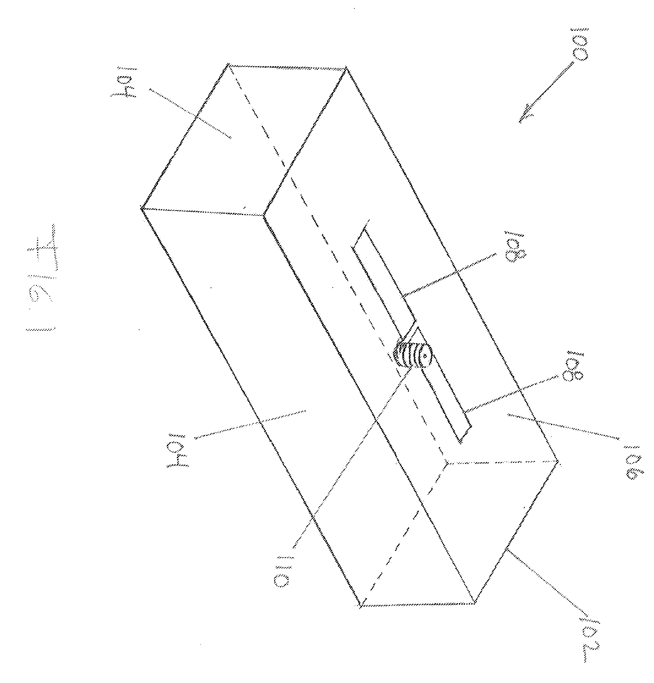

Figure 1 shows an example of an antenna array which is comprised of only one antenna element 100. The antenna element 100 comprises a substrate 102 with a first side 104 and a second side 106. The substrate 102 in this diagram is block shaped and the inside is shown using hidden lines. The first side 104 and the second side 106 are on opposite sides of the block. There is a dipole antenna 108 which comprises two strips which are mounted on the second side 106. There is a first connection 110 which is attached to the two dipole antenna strips. In this figure it is shown as a screw type radio frequency connector. The ground of one connection is attached to one strip and the pin connection is attached to the other strip. Different types of radio frequency connections could be used for example a shielded connection with two wires could also be used. Also instead of using a connector the connection could be a hard connection between a transmission line and the antenna elements.

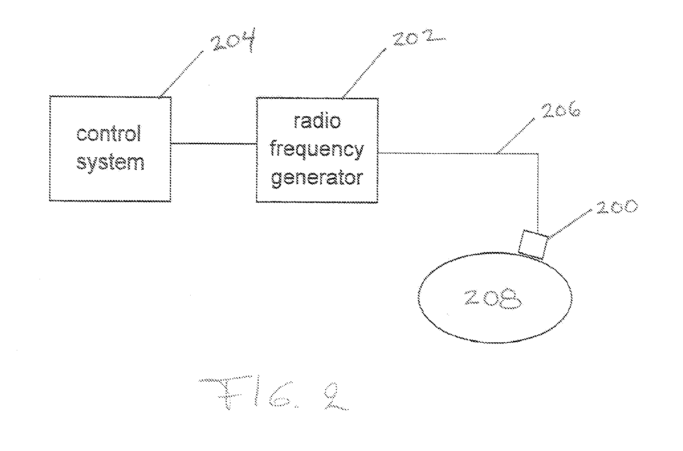

Figure 2 shows a radio frequency system for a magnetic resonance imaging system. There is a subject 208 with an antenna array 200 adjacent to the surface of the subject 208. In this figure the antenna array comprises only one element. There is a transmission line 206 which connects the antenna array 200 to the radio frequency generator 202. The radio frequency generator produces radio frequency energy that is able to control the phase and amplitude applied to the antenna array 200. The radio frequency generator is controlled by control system 204.

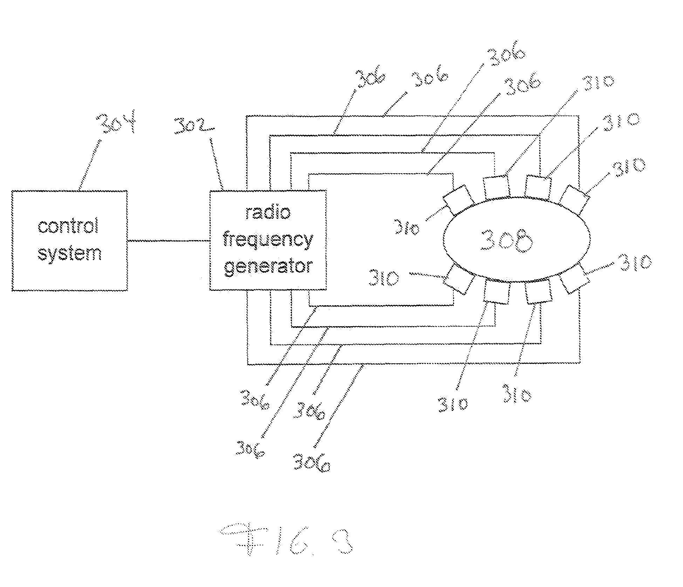

Figure 3 shows a radio frequency system similar to that is shown in figure 2, except in this case there are a larger number of antenna elements 310 that comprise the antenna array. Elements with the last two same digits are identical or perform the same function as elements shown in figure 2. Elements which have been previously discussed will not necessarily be discussed again in the description of this drawing. In this diagram the antenna array is comprised of eight antenna elements 310. Each antenna element 310 can comprise one or more full antennas. Each antenna element 310 has its own transmission line 306 connecting it to the radio frequency generator 302. The radio frequency generator is able to independently control the amplitude and phase of radio frequency applied to each antenna element. As in the previous figure, control system 304 controls the radio frequency generator 302. The antenna elements in figures 2 and 3 can be held in place in a variety of different ways. They can be embedded in a carrier such as a cushion, a subject holder or they can be integrated into a belt like array or substrate which can be placed on or around a subject.

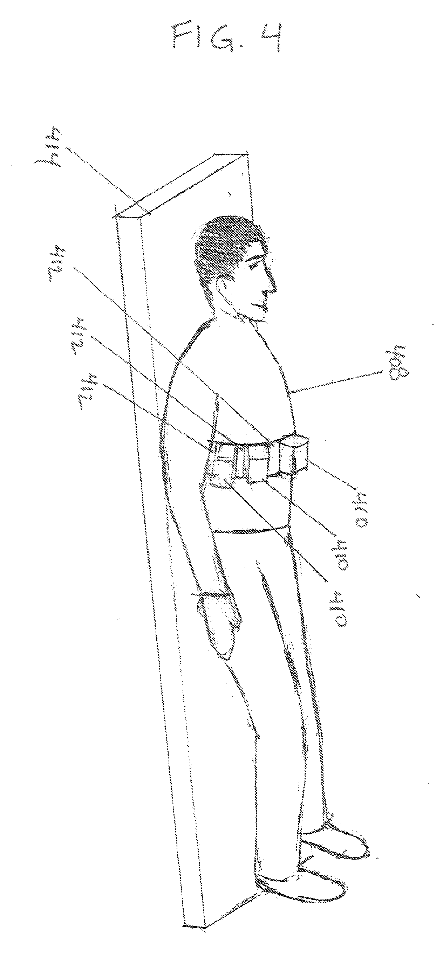

Figure 4 shows an example of a subject 408 residing on a subject support 414. The antenna elements 410 are held in place around the subject 408 by a belt 412. A subject 408 wearing such an antenna array could easily be placed within the bore of a magnetic resonance imaging magnet. In this embodiment, each element is provided with a RF-signal with a controllable phase and amplitude for transmit. For receive, the signal of each element is independently stored in the system for simultaneous processing or post-processing. However, in other embodiments, any alignment of the elements is possible. For example, using several belt like arrays to increase the field of view in the longitudinal direction. For cardiac imaging, two arrays can be placed at the anterior and posterior side of the chest. If the substrate comprises a fluid, then other solutions may become practical. In other embodiments, several dipole antennas per substrate and/or element are possible.

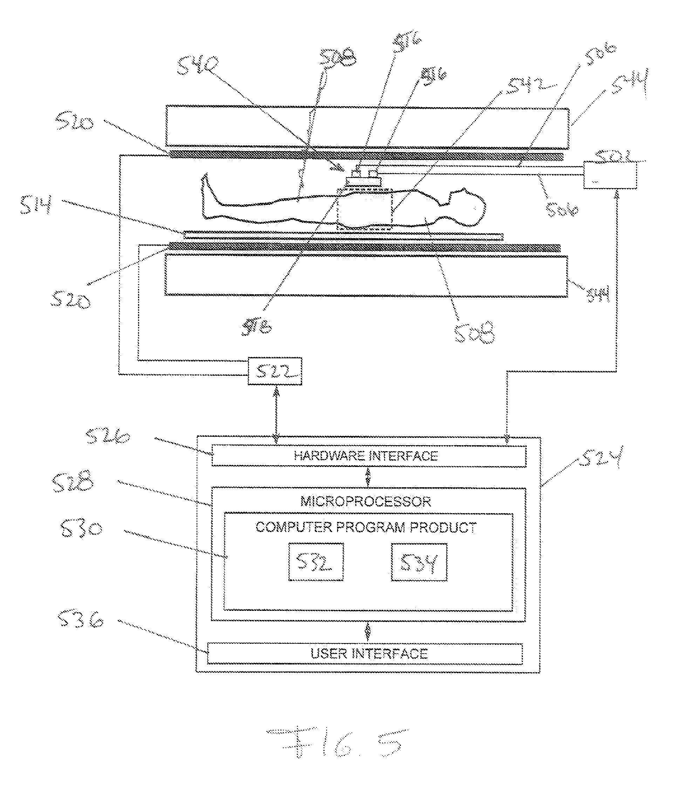

Figure 5 shows an embodiment of a magnetic resonance imaging system according to an embodiment of the invention. There is a subject 508 sitting on a subject support 514. The subject support 514 is within the bore of a cylindrical magnetic field means 544. The magnetic field means generate a magnetic field sufficient for acquiring a magnetic resonance imaging image within an imaging zone 542. The magnetic field means 544 can be a permanent, electromagnet or a superconducting magnet. The magnetic field means 544 can be a cylindrical magnet with a bore adapted for receiving a subject, or it can be a split magnet design with two cylindrical magnets located coaxially next to each other. The magnetic field means can also be a split coil or so a called open magnet design. Also inside of the bore of the magnet are the magnet field gradient coils 520, the magnetic field gradient coils 520 are connected to the magnet field gradient power supply 522. Adjacent to the subject 508 is an antenna array 540 according to an embodiment of the invention. In this example there is a substrate 518 with two dipole antennas 516. There is a transmission line 506 which connects each dipole antenna 516 to a radio frequency power supply 502. The radio frequency power supply 502 and the magnetic field gradient power supply 522 are connected to the hardware interface 526 of a computer system 524. The hardware interface 526 is adapted for controlling these two pieces of hardware. The computer system comprises a microprocessor 528 which is adapted for executing a computer program product 530. In this example the computer program product comprises a reconstruction module 532 for taking magnetic resonance imaging data and constructing magnetic resonance images and a radio frequency power supply control module 534. In this example the microprocessor controls the radio frequency power supply 502. The computer system 524 also comprises a user interface 536 which can be used by an operator to control the magnetic resonance imaging system.

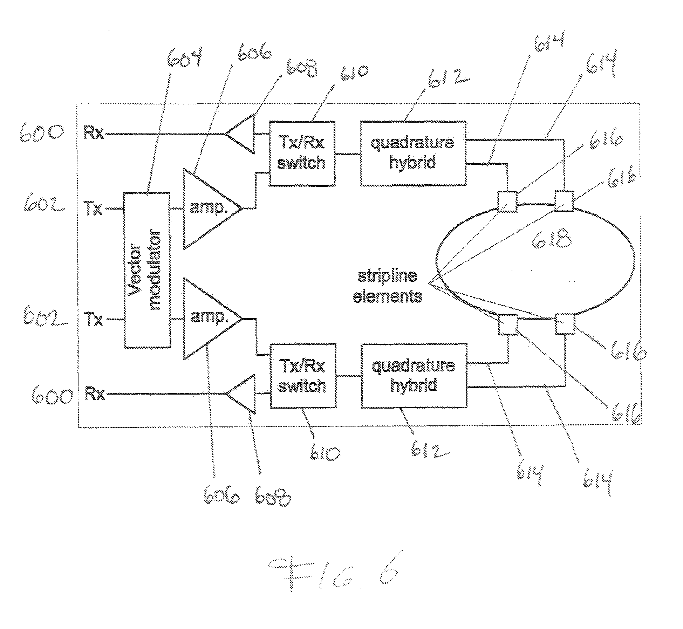

Figure 6 shows an embodiment of a radio frequency system for a magnetic resonance imaging system. There are two transmit channels 602 and two receive channels 600. Both transmit channels are inputted into a vector modulator 604. The vector modulator 604 is for adjusting the phase of the two transmit channels 602. After the vector modulator 604 each transmit channel goes through an amplifier 606. The amplifier 606 amplifies and conditions the signal for output. Each amplifier 606 is connected to a transmit or receive switch 610. With the transmit or receive switch 610 the system can be used for transmitting and receiving an RF signal for performing a magnetic resonance imaging. Each receive channel 600 is connected to the output of an amplifier 608. The amplifier serves to isolate and condition and amplify the received radio frequency signals during magnetic resonance imaging. The amplifiers 608 are each connected to a transmit or receive switch 610. Each transmit or receive switch 610 is then connected to a quadrature hybrid power diverter and combiner 612. The quadrature hybrid 612 is used to connect each signal via a transmission line 614 to two antenna elements 616. Each antenna element 616 has its own transmission line 614 that connects it to the quadrature hybrid 612. In this figure there are four antenna elements 616 which comprise the antenna array. There are two antenna elements 616 for each channel. The antenna elements 616 are positioned around a transfer cross section of a subject 618.

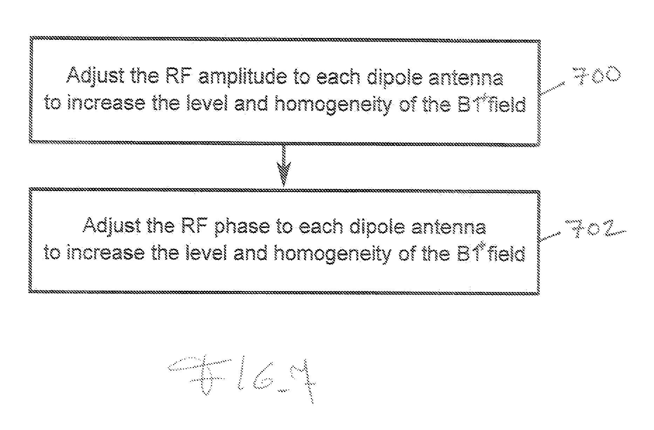

Figure 7 shows an embodiment of a method according to the invention. The first step is to adjust the RF amplitude to each dipole antenna to increase the level and homogeneity of the B₁⁺ field 700. The second step is to adjust the RF phase to each dipole antenna to increase the level and homogeneity of the B₁⁺ field 702. By controlling the phase and amplitude of multiple antenna elements, the B₁⁺ field can be made more uniform and homogeneous. This increases the image quality of the magnetic resonance imaging image.

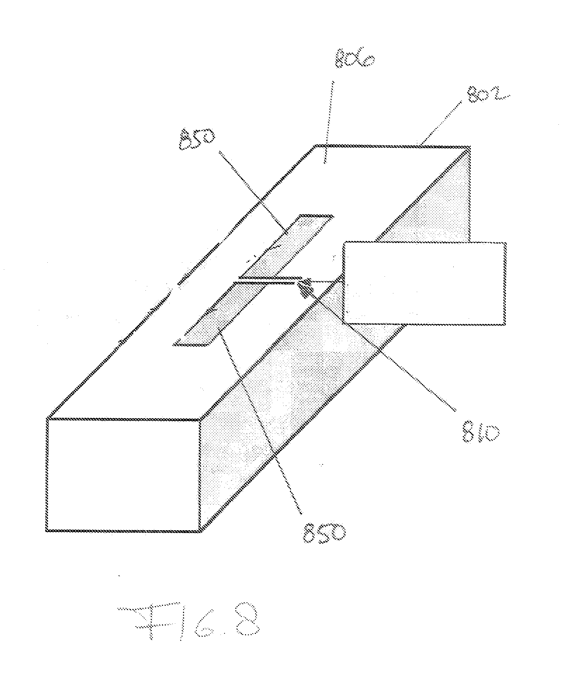

Figure 8 shows the construction details of a dipole antenna according to an embodiment of the invention. There is a substrate 802 with a second side 806 and a first side. The first side is not shown in this diagram. The dipole antenna is constructed from two conductive strips 850. Each conductive strip has a first connection 810. The first connection 810 should be connected to a matched and balanced power source. The conductive strips 850 are chosen so that their length is one quarter of a wavelength of the wavelength of a wave which is desired to be launched into the dielectric substrate 802.

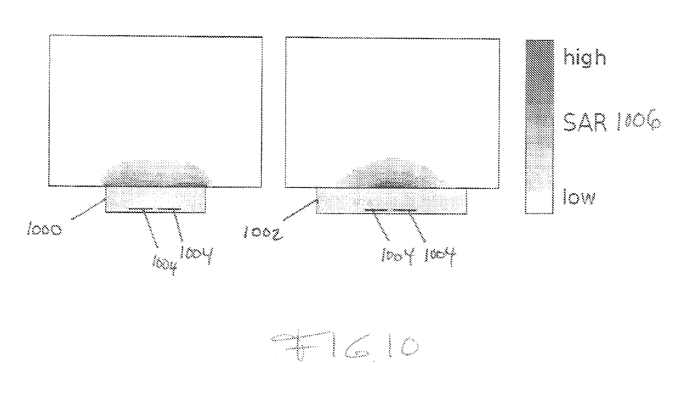

In figure 8 a schematic design of the antenna element is shown: A dipole antenna, consisting of two conducting rods, is placed adjacent to a high permittivity, low conductivity dielectric substrate. The thickness of the substrate should be approximately λ/4 in the dielectric, where λ is the wavelength of the electromagnetic wave. The dielectric is then placed adjacent to the subject. For an optimal B₁⁺/SAR ratio, the length of each conducting rod should equal λ/4 in the dielectric for the center frequency of interest. In this way, the antenna impedance is real and the antenna is optimized to transmit signal into the direction of the subject, which minimizes the radiation that is transmitted in the backward direction. The length of the dielectric substrate should equal at least twice the length of the conducting strips to ensure that the high E-fields at the end of the strips remain inside the dielectric. Otherwise, high SAR levels occur inside the subject as is shown below in figure 10.

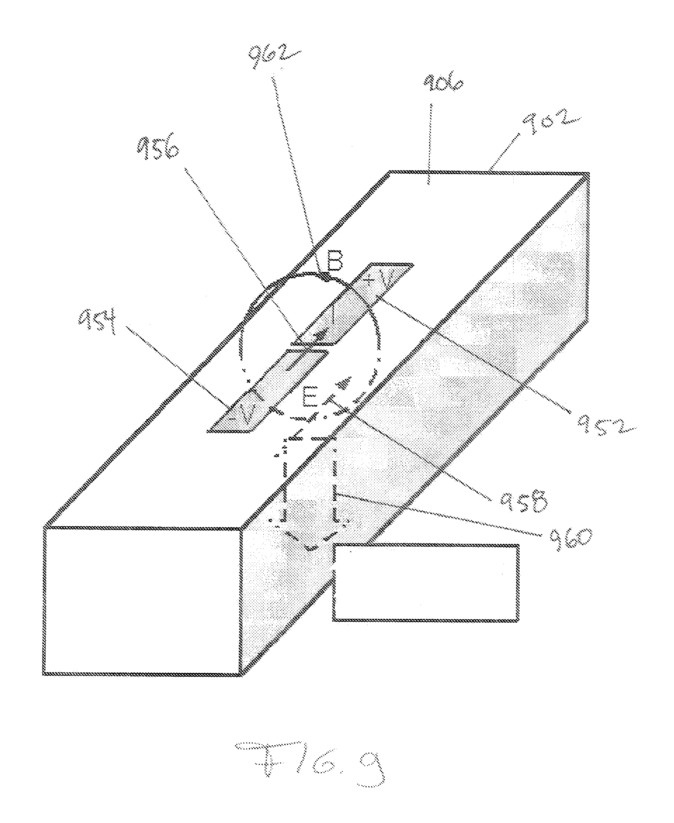

Figure 9 shows an example of how a traveling wave is launched by an antenna element according to an embodiment of the invention. There is a substrate 902 which comprises a dielectric material. There is a second side 906, and a first side which is not visible in this diagram. There is a first conductive strip 952 and a second conductive strip 954. There is a positive voltage on the first conductive strip 952 and there is a negative voltage on the second conductive strip 954. As the alternating radio frequency current is applied to these two strips the potential on these strips changes and the current goes back and forth. Vector 956 shows the direction of current flow when conductive strip 952 is positive and conductive strip 954 is negative. The direction of the electric field is shown by arrow 958. The position and orientation of magnetic field lines are shown by circle 962. This arrangement induces an electromagnetic wave to be launched from the second side 906 through the dielectric substrate 902 towards the first side. The direction of this traveling wave is shown with arrow 960.

The antenna shown in figure 9 is designed such that a planar traveling wave can be excited efficiently. This requires the generation of magnetic fields and electric fields orthogonal to each other and orthogonal to the traveling wave direction. Figure 9 shows that the proposed antenna fulfills these requirements. The wave is generated in a dielectric substrate to prevent near-field SAR peaks from heating up the tissue. The permittivity of the dielectric should equal the human tissue at the interface and the conductivity should be as low as possible.

Figure 10 shows an example of simulated specific absorption ratio levels in a phantom (εᵣ = 50, σ=0.6) with a substrate length of 10 cm and 15 cm. Substrate: (εᵣ = 80, σ=0.05). The figure demonstrates that the SAR level increases at the endings of the substrate if the substrate is too short. This simulation shows the benefit of having the dielectric extend beyond the dipole strips by at least a quarter wavelength. These simulation results are shown. The first simulation result is above a substrate 1000 where the end extends less than one quarter of the wavelength beyond the conductive strips 1004 of dipole antenna. The second simulation result is above a substrate 1002 and extends one quarter of the wavelength or more beyond the conductive strips 1004 of a dipole antenna. Color bar 1006 indicates the value of the calculated SAR. The calculation is shown in arbitrary units. This simulation shows that extending the substrates at least a quarter of a wavelength beyond the ends of the conductive strips 1004 has the effect of reducing the SAR.

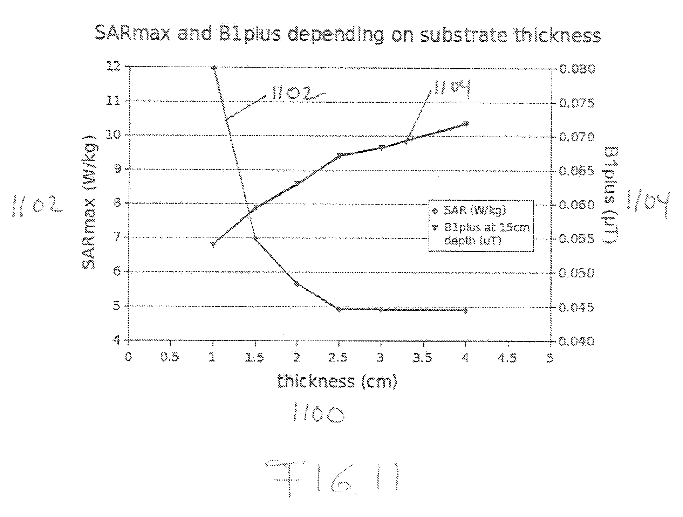

Figure 11 shows the maximum specific absorption ratio 1102 and the value of B₁⁺ 1104 as a function of the substrate thickness 1100. The SAR level 1102 at the substrate-subject boundary as a function of substrate thickness 1100, normalized for 1 W delivered power. Figure 11 also shows the B₁⁺ level 1104 at 15 cm depth. For this case, figure 11 demonstrates that the minimum thickness of the substrate, without having the near-field enter the subject, is 2.5 cm. i.e. λ/4 at 7 Tesla and epsilon is 90. Curve 1102 indicates the maximum SAR level. This value goes up with increasing substrate thickness. In practice problems will arise if the substrate becomes too thick because of coupling with nearest neighbor elements.

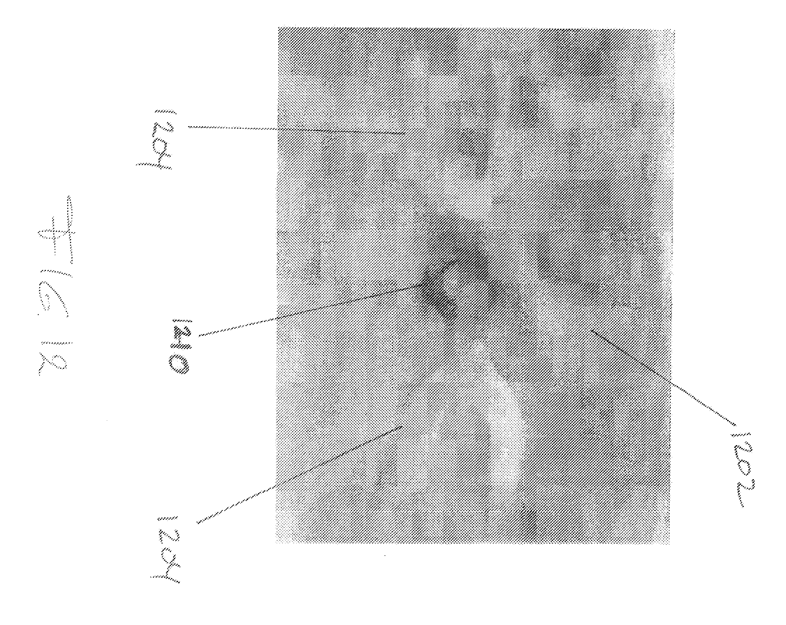

Figure 12 shows an embodiment of a dipole antenna according to the invention. Two V-shaped conductive strips 1204 are shown mounted on a dielectric substrate 1202. The point of the V-strips point in the direction of the first connection 1210.

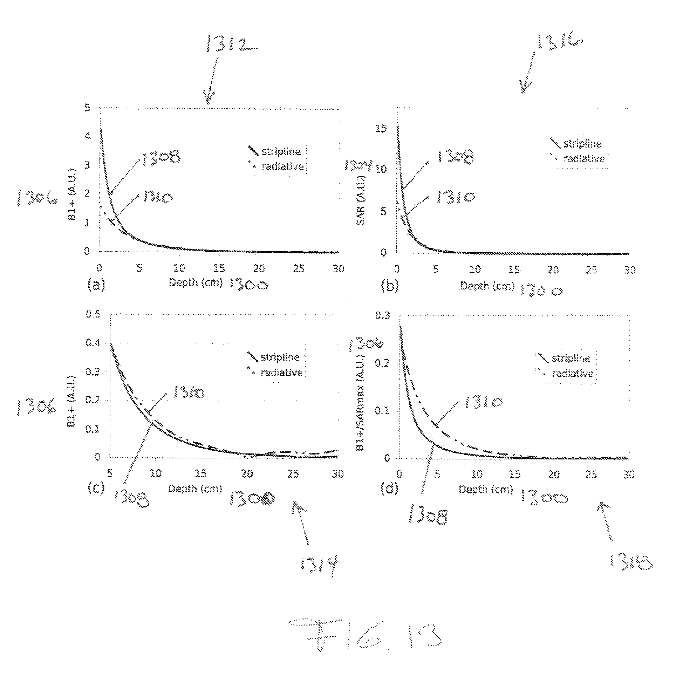

For a practical realization of the antenna, the permittivity of the substrate needs only be approximately equal to the permittivity of the body. A suitable substrate is distilled water (The permittivity of water is 80 and of muscle tissue is 60). The drawback of water, however, is that it generates MR signal. A better solution would be to use Fomblin as a high epsilon liquid with low conductivity that does not generate MR signal. If the subject's skin surface is flexible in the region of interest, then a more convenient solution is the usage of ceramic materials. They can be formed in any desired shape that fulfills the conditions, while good connection is guaranteed by pressing the elements slightly onto the skin. If the elements do not connect tight enough, a water-like gel (high permittivity) would ensure the transmission of the electromagnetic wave. The transverse transmit profile can be improved (widened) by cutting the conductive strips in a V-shape such as indicated in figure 12. Figure 13 shows a simulation showing the comparison of a dipole antenna according to the embodiment of the invention and a conventional stripline magnetic resonance imaging antenna. The axis 1300 shows the depth in centimeters into a phantom. Axis 1302 is the B₁⁺ field in arbitrary units. Axis labeled 1304 show the specific absorption ratio in arbitrary units. Axis 1306 show the B₁⁺ field normalized by the maximum specific absorption ratio in arbitrary units. The solid lines indicated by 1308 are the results for the stripline antenna. Those with the dashed line and marked 1310 are the results for the dipole antenna. Plot 1312 shows the B₁⁺ profile for the dipole antenna and a stripline element. Plot 1314 shows the same data as in figure 1312 but for a zoomed in depth range. Plot 1316 shows the specific absorption ratio profile for a dipole antenna and stripline element and plot 1318 shows the B₁⁺ profiles normalized to the maximum specific absorption ratio level.

The performance of the radiative antenna has been characterized by fdtd (finite difference time domain) simulations. The transmitted B₁⁺ profile of the dipole antenna is presented plot 1312 of figure 13, along with the transmitted B₁⁺ profile of a stripline element. In plot 1316 of figure 13, the SAR distribution in depth of both antennas is presented. Although the B₁⁺ in the near-field region is higher for the stripline element, the B₁⁺ gain at depths beyond 5 cm is higher for the dipole antenna, cf. plot 1314 of figure 13. At a depth of 10 cm, the dipole antenna achieves a 20% higher level of B₁⁺ in the tissue. The comparison becomes even better if the level of B₁⁺ per unit maximum SAR is considered. This is shown in plot 1318 of figure.

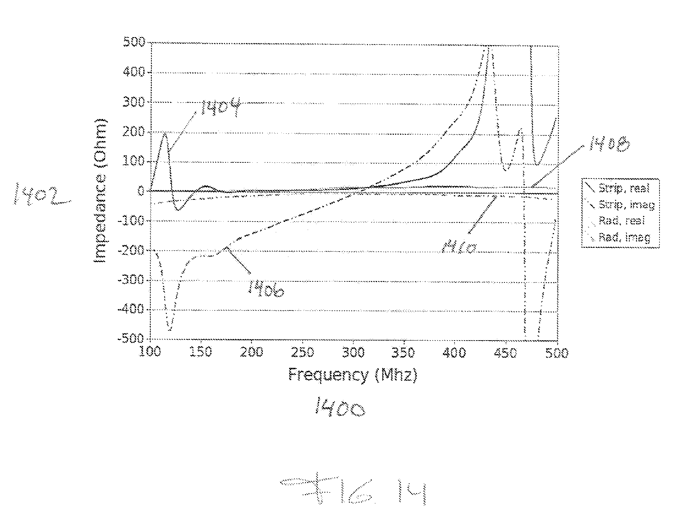

Figure 14 shows the real and imaginary impedance values for a dipole antenna obtained from the simulation of the invention and a conventional stripline antenna. It shows the real and imaginary impedance values for a dipole and a stripline antenna, loaded with a phantom with εᵣ = 75 and σ = 0.5. Axis 1400 is the frequency in megahertz, and axis 1402 is the impedance in ohms. Curve 1404 shows real component of the impedance of the stripline and 1406 shows the imaginary component of the impedance of the stripline antenna. Curve 1408 shows the real component of the impedance of the dipole antenna and curve 1410 shows the imaginary component of the impedance of the dipole antenna.

Embodiments of antenna arrays may have another advantage with respect to conventional antennas. Because the antenna is not a resonant LC-circuit, the impedance is much more constant over a wide frequency range (figure 14). This may result in an application in multi-nuclei MRI where one radiative or dipole antenna design is used for several frequencies.

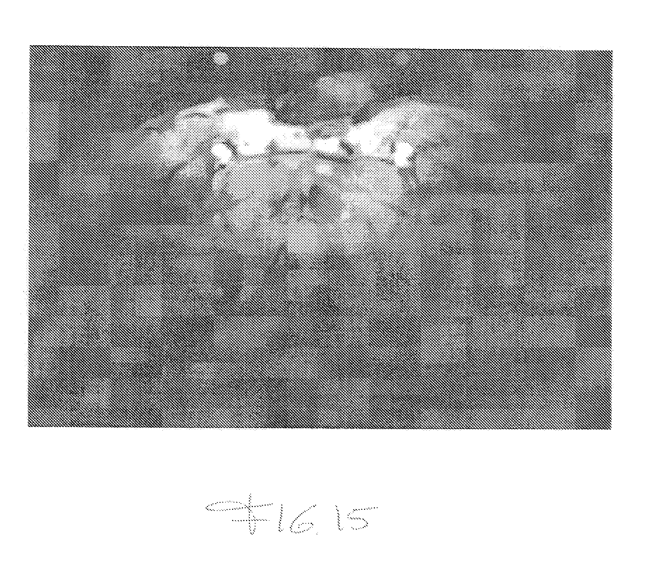

Figure 15 shows an example of a magnetic resonance imaging image acquired using a dipole antenna according to an embodiment of the invention.

A prototype version of a dipole antenna has been realized using a ceramic substrate, Morgan Electro Ceramics K90, and a simple dipole antenna with two conducting strips. The dipole antenna is connected to a transmission line via a matching network to convert the antenna impedance to 50 ohms. After testing the antenna on a gelatine phantom, temperature measurements and MR thermometry show that the dipole antenna indeed causes less temperature rise in comparison to a conventional stripline antenna. Furthermore, measurements on a volunteer prostate at 7 T show that already just one dipole antenna element is able to image deep inside the body (figure 7).

Figure 15: GRE image of the pelvic region with only one dipole antenna element operating in transceiver mode.

### LIST OF REFERENCE NUMERALS:

- 100: Antenna element
- 102: Substrate
- 104: First side
- 106: Second side
- 108: Dipole antenna
- 110: First connection
- 200: Antenna array
- 202: Radio frequency generator
- 204: Control system
- 206: Transmission line
- 208: Transversal cross section of a subject
- 302: Radiofrequency generator
- 304: Control system
- 306: Transmission line
- 308: Transversal cross section of a subject
- 310: Antenna element
- 408: Subject
- 410: Antenna element
- 412: Belt
- 414: Subject support
- 502: Radio frequency power supply
- 506: Transmission line
- 508: subject
- 516: Dipole antenna
- 518: Substrate
- 520: Magnetic field gradient coils
- 522: Magnetic field gradient coil power supply
- 524: Computer system
- 526: Hardware interface
- 528: Microprocessor
- 530: Computer program product
- 532: Image reconstruction module
- 534: Radio frequency power supply control module
- 536: User interface
- 540: Antenna array
- 542: Imaging zone
- 544: Magnetic field means
- 600: Receive channel
- 602: Transmit channel
- 604: Vector modulator
- 606: Transmit amplifier
- 608: Receive amplifier
- 610: Transmit or receive switch
- 612: Quadrature hybrid power diverter and combiner
- 614: Transmission line
- 616: Antenna element
- 618: Transversal cross section of a subject
- 802: Substrate
- 806: Second side
- 810: First connection
- 850: Conductive strip
- 902: Substrate
- 906: Second side
- 952: First conductive strip
- 954: Second conductive strip
- 956: Direction of current flow
- 958: Direction of electric field
- 960: Direction of electromagnetic wave travel
- 962: Position and direction of magnetic field line
- 1000: Substrate with end less than one quarter wavelength long
- 1002: Substrate with end one quarter in wave length long
- 1004: Conductive strip of dipole antenna
- 1006: Color bar indicating specific absorption ratio
- 1100: Thickness
- 1102: Maximum specific absorption ratio
- 1104: B₁⁺
- 1202: Substrate
- 1204: "v" shaped conductive strip
- 1300: Depth
- 1302: B₁⁺ in arbitrary units
- 1304: Specific absorption ratio in arbitrary units
- 1306: B₁⁺ divided by the maximum specific absorption ratio in arbitrary units
- 1308: Calculation for stripline antenna
- 1310: Calculation for dipole antenna
- 1312: B₁⁺ profile for stripline antenna and dipole antenna
- 1314: B₁⁺ profile for stripline antenna and dipole antenna
- 1316: Specific absorption ratio profile for stripline antenna and dipole antenna
- 1318: B₁⁺ profiles normalized to maximum specific absorption level
- 1400: Frequency in MHz
- 1402: Impedance in ohms
- 1404: Real component of stripline antenna impedance
- 1406: Imaginary component of stripline antenna impedance
- 1408: Real component of dipole antenna impedance
- 1410: Imaginary component of dipole antenna impedance

## Claims

1. An antenna array (200, 540) adapted for magnetic resonance imaging, wherein the antenna array comprises at least one antenna element (100, 310, 410, 616), wherein each antenna element comprises:
- a substrate (102, 518, 802, 902, 1000, 1002, 1202, ) with a first side (104) and a second side (106, 806, 906), wherein the substrate comprises a dielectric material, in particular a ceramic material,
- at least one dipole antenna (108, 516, 850, 952, 954, 1004, 1204), wherein the dipole antenna is attached to the second side of the substrate, wherein the dipole antenna comprises a first connection (110, 1210) adapted for connecting the dipole antenna to a transmission line (206, 306, 506, 614).

2. The antenna array of claim 1, wherein the dielectric material has a dielectric constant between 20 and 110, and/or the dielectric material has an electrical conductivity that is lower than 0.1 S/m at the operating frequency of the longest wavelength that the dipole antenna is adapted for launching.

3. The antenna array of claim 1 or 2, wherein the dielectric constant of the dielectric material is equal to the average dielectric constant of a human body.

4. The antenna array of any one of the preceding claims, wherein the antenna array is adapted for receiving radio frequency signals from nuclei inside a subject excited during the acquisition of magnetic resonance imaging data.

5. The antenna array of any one of the preceding claims, wherein the antenna array is adapted for launching an electromagnetic wave from the dipole antenna through the substrate in the direction (960) of the first side for manipulating the orientation of nuclear spins inside a subject during the acquisition of magnetic resonance imaging data.

6. The antenna array of claim 5, wherein the thickness of the substrate is greater than one eighth of the wavelength in the dielectric at the frequency of the longest wavelength of the electromagnetic wave that the dipole antenna is adapted for launching, preferably the thickness of the substrate is greater than one quarter of the wavelength in the dielectric at the frequency of the longest wavelength of the electromagnetic wave that the dipole antenna is adapted for launching.

7. The antenna array of claim 5 or 6, wherein the dipole antenna comprises two conductive strips (952, 954, 1004, 1204), wherein the conductive strips are aligned along an axis, wherein the substrate extends along the axis beyond the end of each of the conductive strips at least an eighth of a wavelength in the dielectric material of the longest wavelength that the dipole antenna is adapted for launching, preferably the substrate extends along the axis beyond the end of each of the conductive strips at least a quarter of a wavelength of the longest wavelength that the dipole antenna is adapted for launching.

8. The antenna array of any one of claims 5 through 7, wherein the dipole antenna of each antenna element is tuned for launching electromagnetic waves with a first frequency, and wherein the dipole antenna comprises two conductive strips, wherein length of the strips is chosen such that length of each strip is one quarter of the wavelength of the electromagnetic wave at a first frequency in the dielectric.

9. The antenna array of any one of claims 5 through 8, wherein the antenna is adapted for launching at least two different frequencies of electromagnetic waves.

10. The antenna array of claim 9, wherein the antenna is further adapted for launching electromagnetic waves for performing radio frequency hyperthermia treatment of the subj ect.

11. The antenna array of any one of the preceding claims, wherein the dipole antenna comprises two conductive strips, wherein each conductive strip is "V" shaped (1204), and wherein the two conductive strips are attached to the substrate such that the points of the "V" for both conductive strips are adjacent to each other.

12. The antenna array of any one of the preceding claims, wherein the first side is adapted for receiving a subject and/or the first side is adapted to the contour of the subject and/or the dielectric substrate comprises a fluid and/or the first side is adapted for receiving a gel that facilitates the transmission of electromagnetic waves from the first side to the subject.

13. A radio frequency system for a magnetic resonance imaging system comprising:
- an antenna array (200, 540) according to any one of any one of the preceding claims,
- a radio frequency generator (202, 302) adapted for supplying each dipole antenna of the antenna array with radio frequency power with at least a first frequency, wherein the radiofrequency power is supplied through a second connection, wherein the radio frequency generator is adapted for controlling the amplitude and phase of the radio frequency power supplied to each dipole antenna,
- a set of transmission lines (206, 306, 506) adapted for connecting to the first connection and the second connection,
- a control system (204, 304, 524, 534) adapted for controlling the radio frequency generator.

14. A computer program product comprising machine executable instructions for execution on the control system of the radio frequency system of claim 15, the machine executable instructions comprising the steps of:
- adjusting the amplitude (700) of radio frequency energy received by each dipole antenna from the radio frequency generator in order to increase the level and homogeneity of the B₁⁺ field within the subject,
- adjusting the phase (702) of the radio frequency energy received by each dipole antenna from the radio frequency generator in order to increase the level and homogeneity of the B₁⁺ field within the subject.

15. A magnetic resonance imaging system adapted for acquiring magnetic resonance image data comprising:
- a magnetic field generation means (544) for generating a magnetic field for orientating the magnetic spins of nuclei,
- a radio frequency system (502, 506, 540) according to claim 15,
- a magnetic field gradient coil (520) for spatial encoding and manipulating the orientation of the magnetic spins of nuclei,
- a magnetic field gradient coil power supply (522) for supplying current to the magnetic field gradient coil,
- a second control system (524, 532) for reconstructing images from the magnetic resonance imaging data.
